# EUROPEAN PATENT SPECIFICATION

(11) **EP 1 879 270 B1**
(45) Date of publication and mention of the grant of the patent: **10.10.2012**
(21) Application number: 07108434.7
(22) Date of filing: 18.05.2007
(51) Int. Cl.: H01S 5/068

(54) **Method for safely controlling the emission power of a laser and corresponding circuit**
Verfahren zur sicheren Steuerung der Emissionsleistung eines Lasers und entsprechende Schaltung
Procédé de contrôle sécurisé de l'énergie d'émission d'un laser et du circuit correspondant

(30) Priority: 29.05.2006 IT MO20060168
(43) Date of publication of application: 16.01.2008
(73) Proprietor: M.D. MICRO DETECTORS S.p.A., I-41100 Modena (IT)
(72) Inventor: Del Monte, Mauro, 41100, Modena (IT); Messori, Marco, Sant'anna di San Cesario MO 41018 (IT)
(74) Representative: Modiano, Micaela Nadia

(56) References cited:
- WO-A-01/15289
- DE-A1- 4 010 054
- DE-A1- 4 327 343
- JP-A- 62 282 474
- US-A- 5 175 641
- US-A- 6 016 326

## Description

The present invention relates to a method for safely controlling the emission power of lasers and to the corresponding circuit for performing the method. Preferably, the present invention is applied in products which use solid-state or semiconductor lasers.

Lasers are subjected to safety standards in order to prevent dangerous situations for the user or for the apparatus in which they are used. Currently there is a standard, known as IEC 60825, which classifies the danger level of the laser as a function of the emitted power and wavelength and defines the conditions for modulation and use, the safety checks and the safety characteristics against faults of the driving and control circuits.

In particular, solid-state lasers, used in the field of industrial sensors, must have a limitation of the emitted power such as to not damage the retina of the user.

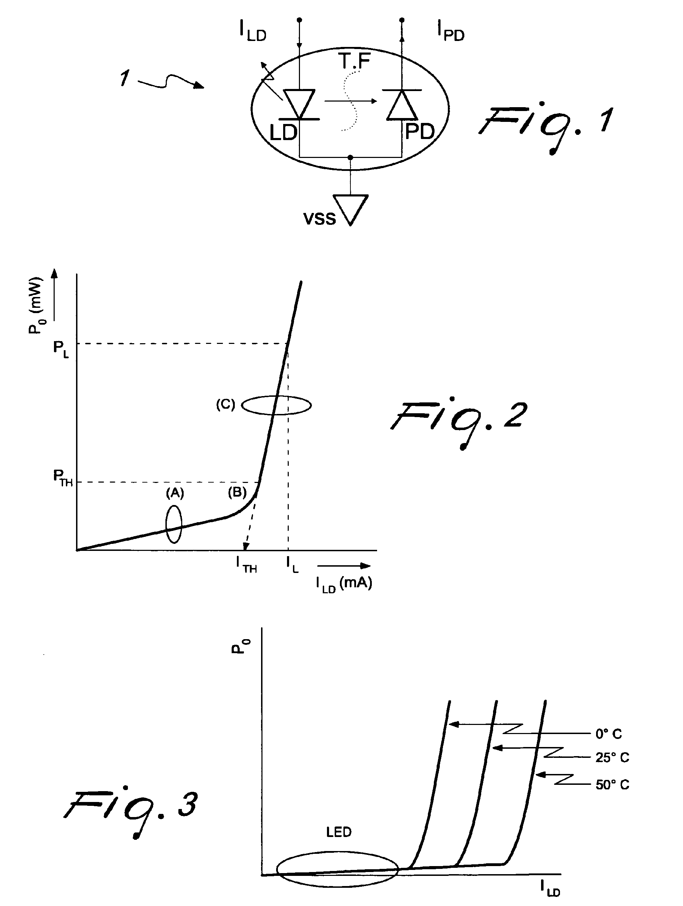

Normally commercially available solid-state lasers are constituted by a module with two elements, which are shown schematically in Figure 1: a semiconductor junction (LD), which is adapted to emit laser light when it is crossed by an electric current (I_{LD}), and a photodiode (PD), which is adapted to detect the light emitted by the junction LD and to produce accordingly an electric current (I_{PD}).

The typical laser module, designated by the reference numeral 1 in Figure 1, therefore has the appearance of a three-pole device, in which one pole is at a common voltage (VSS or ground) and the other two poles are designed to be connected respectively to a source of current I_{LD} and to a detector of the current generated in the photodiode (I_{PD}), typically a microcontroller.

As is known, the power Po emitted by a laser diode as a function of the pumping current I_{LD} has the plot of Figure 2. In particular, in the curve that links the power Po to the current I_{LD} it is possible to identify a spontaneous emission region (A) and a stimulated emission region (C), which are separated by a knee (B). The projection of the stimulated emission region (C) on the axis of the current I_{LD} is typically known as threshold current (Iₜₕ) and corresponds to the value of the pumping current required to achieve a reversal of population and therefore a laser action.

The first part of the curve (A) has the appearance of a straight line or of a substantially straight segment and corresponds to a state of the laser diode in which the emitted light is substantially incoherent. Such light is similar to the light emitted by a normal LED and for this reason such region (A) is also known as "LED region".

The LED region of the curve is substantially insensitive to temperature variations. It has considerable thermal stability and a repeatability which is comparable to the characteristics of an ordinary LED, while the position of the knee and the second part of the curve are thermally highly unstable, as shown by the curves at various temperatures shown in Figure 3.

The control circuits currently in use control the power emitted by the laser by utilizing the photodiode PD that exists in the module 1.

In order to comply with applicable safety standards, the control circuits of lasers must have a level of safety which is single fault-proof, i.e., if the control circuit is affected by a single fault the system must ensure that the laser emits a power level which does not exceed the stated class.

Ensuring that the control system of a laser is single fault-proof requires a dual-channel control circuit. A dual-channel system must therefore comprise a dual control photodiode.

Since ordinary solid-state lasers are built with a single photodiode inside the module, to ensure safety it is necessary to add a photodiode outside the module. This entails a considerable additional cost, since not only a second photodiode is required, but it is also necessary to use an optical system which collects part of the light emitted by the laser LD and directs it toward the additional photodiode.

DE 43 27 343 A1 discloses a method for controlling the emission power of a laser as defined in the preamble of claim 1.

DE 40 10 054 discloses the use of an additional photodiode in order to guarantee safe laser operation even if one photodiode fails.

The aim of the present invention is to solve the problem of dual-channel safety control by using the structure of commercial lasers to reach a level of safety which is required or higher than the one required by the standard without modifying the existing arrangement of the laser and the photodetector.

Within this aim, an object of the invention is to provide a control method which do not require additional photodetectors but preferably use a single photodetector, which is optionally already integrated in commercially available laser modules or exists in the apparatus in which the laser is installed.

Another object of the invention is to simplify the production or updating of an emitted power control system.

Another object of the invention is to provide a method which is highly reliable, relatively easy to provide and at competitive costs.

This aim and these and other objects, which will become better apparent hereinafter, are achieved by a method for safely controlling the emission power of a laser coupled to a photodetector, in which the power emitted by the laser is substantially insensitive to variations in temperature or other environmental variables for at least one value of the pumping intensity, characterized in that it comprises the steps of pumping the laser, at preset instants, according to said at least one value of the pumping intensity, and of measuring a corresponding response of the photodetector to the light emitted by the laser during these instants, in order to check the correct operating condition of the photodetector.

Disclosed is also a circuit for safely controlling the emission power of a laser coupled to a photodetector in order to detect the light emitted by the laser, in which the power emitted by the laser is substantially insensitive to variations in temperature or other environmental variables for at least one value of the pumping intensity, said circuit comprising pumping means which are adapted to pump the laser at preset instants according to said at least one value of the pumping intensity, and means for measuring a corresponding response of the photodetector to the light emitted by the laser during said instants, in order to check the correct operating condition of the photodetector.

Preferably, the laser is of the solid-state type and is normally pumped over threshold so that it emits laser light, while the value of the intensity at which the power emitted by the laser is substantially insensitive to temperature variations is a value of the current which is below the stimulated emission threshold.

Further characteristics and advantages of the invention will become better apparent from the following detailed description of a preferred but not exclusive embodiment of the method and apparatus according to the invention, illustrated by way of non-limiting example in the accompanying drawings, wherein:
Figure 1 is an electrical diagram of a known laser module;
Figure 2 plots the power emitted by a laser diode as a function of the pumping current;
Figure 3 shows the plot of Figure 2 as a function of the junction temperature;
Figure 4 is view of a control circuit of the laser of Figure 1 according to a particular embodiment of the invention;
Figure 5 is a flowchart of a control procedure according to a preferred embodiment of the invention;
Figure 6 plots the behavior over time of the pulses generated in some components of Figure 4 in case of regular operation of the laser module.

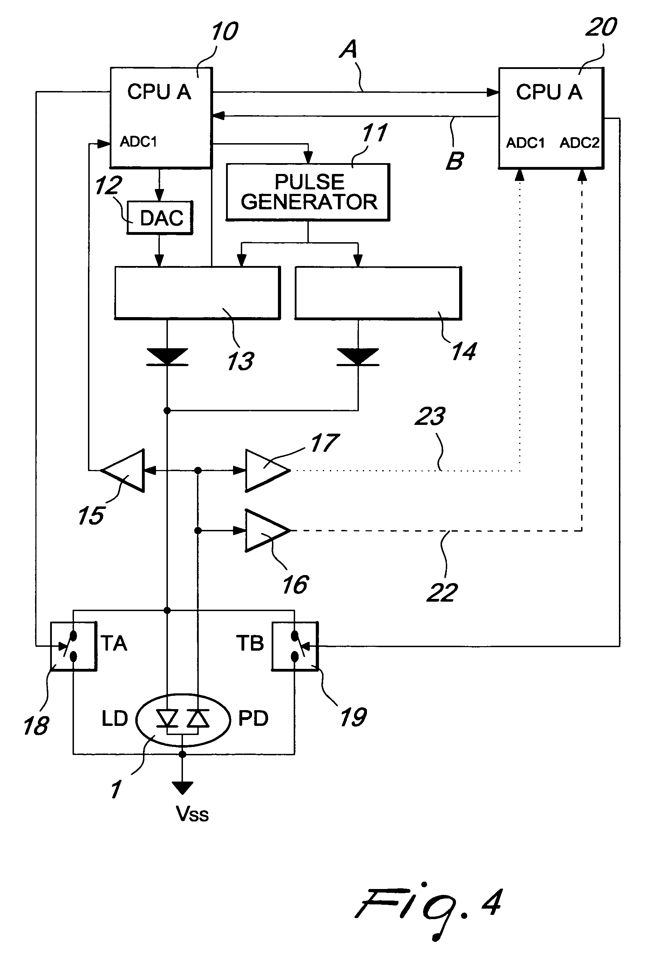

The circuit according to a preferred embodiment of the invention is shown in Figure 4. Such circuit is connected to a laser module 1 of the type shown in Figure 1, which is formed by a semiconductor laser LD and by a photodiode PD, which is also of the semiconductor type and preferably silicon-based. The module 1 has a terminal at a constant voltage VSS, and two safety switches 18 and 19 connect the terminal of the laser LD to the node at common voltage VSS, so as to short-circuit the laser diode LD in case of danger.

The circuit comprises a first processor 10, preferably a microcontroller CPU A, which is connected to means for pumping over threshold the laser LD, which are formed by a pulse generator 11, by a digital/analog converter or DAC of the serial type 12, and by a voltage-controlled source 13 for the pumping current of the laser I_{LD}.

The first microcontroller CPU A is capable of switching off the laser if required, since it is connected in output to a control terminal of the safety switch 18. However, the main purpose of the microcontroller CPU A is to keep the power emitted by the laser constant at the value stored in a flash memory of the microcontroller CPU A.

For this purpose, there is a first feedback loop 21, in which the microcontroller CPU A is connected to the photodiode PD and to the means for pumping over threshold, as shown in Figure 4. The microcontroller stores instructions for comparing the emitted peak laser power, measured via the photodiode, and a peak power stored in the memory of the microcontroller and for adjusting the means for pumping over threshold according to the outcome of the comparison.

In this manner, the power emitted by the laser becomes independent of the temperature of the laser and remains constant regardless of any oscillations of the power/current characteristic shown in Figure 3.

The first loop 21 of the particular circuit shown is completed preferably with a transimpedance amplifier 15 followed by a signal buffer in order to connect the photodiode PD to an analog input ADC1 of the microcontroller CPU A, so that the microcontroller can measure the value of the peak power of the laser LD by reading the current generated in the photodiode PD.

The circuit is provided with a means for pumping below threshold, for pumping the laser LD below the amplified stimulated emission threshold at preset instants, so that at those instants the laser emits substantially incoherent light.

In the particular embodiment of Figure 4, the below threshold pumping means is constituted by the pulse generator 11, which is connected in output to a constant current source 14, which is adapted to inject into the laser diode LD a current whose intensity is lower than the threshold value Iₜₕ shown in Figure 2. In particular, this intensity is chosen in the straight portion of the curve of Figure 2, preferably at the lowest possible operating temperature of the junction, in order to avoid falling into a knee region if the temperature of the junction drops. For example, for a typical laser diode with a threshold current which can vary between 40 and 70 mA, a below threshold current value which can be selected for the purposes of the present invention can be 10 mA.

In the case of a laser diode, such as the one shown in the figure, the light emitted by the laser LD pumped below threshold is incoherent and substantially corresponds to the light emitted by an LED. The response of the photodiode to the LED light of the diode LD pumped below threshold is a term which defines the correct operation of the photodiode.

Accordingly, means are provided for measuring a response of the photodiode to the incoherent light emitted by the laser when said laser is pumped to a constant below-threshold value.

More generally, the invention comprises means for measuring the response of the photodetector when the laser is pumped in a region of the power-pumping intensity characteristic in which the laser is substantially insensitive to variations in temperature or other external variables, such as vibrations.

Going back to Figure 4, the means for measuring the response of the photodiode PD to the LED light are constituted by a second processor 20, for example a microcontroller (CPU B), which is synchronized with the first processor 10 by means of a communication line and is connected to the laser module 1 so as to form a second loop 22 which is adapted to control the integrity of the laser power-photodiode current transfer function. The loop 22 is formed by the microcontroller CPU B, by the photodiode PD, and by the switch 19, which is controlled by the microcontroller CPU B.

In this case, there is no need for a feedback to adjust the power emitted by the laser LD in the LED region, since the characteristic of the laser in the LED region is practically independent of the temperature of the laser, as shown in Figure 3. In practice, oscillations of around 5-10% can be observed also in this region, but they are in any case far smaller than those which can be observed in the over-threshold operating region. However, if the variation of the incoherent light energy emitted at a constant current in the LED region is known, as a function of the temperature, it is also possible to provide a simple external current compensation network in order to keep the emission constant in the temperature range being considered.

Therefore, it is sufficient to use the constant current source 14 (which is optionally temperature-compensated), which injects into the laser diode LD, at preset instants, a current pulse "LED" of preset intensity, which necessarily must be matched by a known value of the power emitted by the laser, obtained from the curve of the laser, which is known to the manufacturer.

In order to check the correct operation of the photodiode PD, the microcontroller CPU B stores instructions for comparing the response of the photodiode to the incoherent light emitted by the laser LD with an expected value of the current or with an expected current value interval, which is preferably centered on the value expected at a certain temperature and has a range of for example 20%.

If this response is different from the expected value or lies outside the interval of values, the microcontroller CPU B is programmed to switch off the laser LD by closing the switch 19. Each deviation from the expected response is in fact a symptom of damage to the photodiode PD and therefore of an inability thereof to detect correctly the light emitted by the laser LD in any pumping condition, above threshold or below threshold.

The second loop 22 is completed by a transimpedance amplifier 16, which connects the photodiode PD to an analog input ADC2 of the microcontroller CPU B and is preferably composed of a cascade of an amplifier, an analog switch controlled by the first processor 10, and a two-stage high-gain amplifier. These three stages in cascade allow to select and amplify only the component that corresponds to the below-threshold current.

The circuit of Figure 4 also has a third loop 23, which is formed by the photodiode PD, by the microprocessor CPU B and by the switch 19, and has an amplifier stage followed by a signal buffer 17 on the branch for return toward the microprocessor CPU B. The third loop 23 forms an independent channel which allows to check the ability of the first processor 10 to control and keep constant the power emitted by the laser LD. If an error damages the operation of the first loop 21, the third loop replaces the first one in order to ensure protection.

For this purpose, the microcontroller CPU B further stores instructions for switching off the laser by means of the switch 19 if, by means of the photodiode PD, no power emitted by the laser is detected although the laser is pumped above threshold.

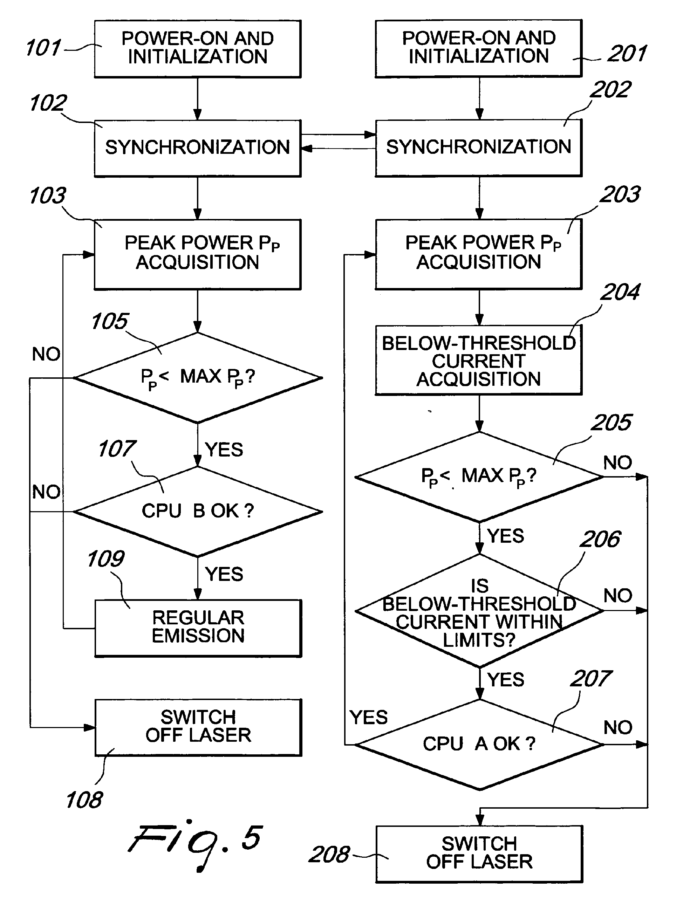

The operation of the invention can be described schematically by means of the diagrams of Figure 5, which illustrate the main procedures performed by the first processor 10 (left chart) and by the second processor 20 (right chart) in a preferred embodiment of the invention.

At the power-on and initialization step (101, 201), the microprocessor CPU A activates a pulsed pumping at a fixed frequency of 125 kHz and with a duty cycle of 50%. The serial digital/analog converter (DAC) 12 forces the voltage-controlled source 13 to inject into the laser diode LD a current which is capable of keeping it switched off.

Subsequently, the CPU A drives the DAC 12 so that it gradually increases the current to the preset value in the so-called trimming step, which is stored in the flash memory of the microcontroller CPU A. This "soft" start is preferred in order to avoid power peaks when the circuit is switched on.

Subsequently, the two microcontrollers CPU A and CPU B are mutually synchronized (step 102 and 202) by means of the lines A and B shown in Figure 4 and acquire the peak power of the laser LD respectively through the first loop 21 and the third loop 23 (steps 103 and 203).

At step 103, the microcontroller CPU A processes the signal received at the input ADC1, extracting a current value of the photodiode PD and comparing it with the reference value stored in its memory.

If the detected value exceeds the reference value, the microcontroller CPU A transmits two serial bytes (1 word, 16 bits) to the DAC 12 in order to force the voltage-controlled source 13 to reduce the current injected in the laser LD. In this manner, the current in the laser LD remains constant at the reference value.

If however the value of the serial word transmitted to the DAC 12 exceeds a preset value defined during design (step 105), the laser is switched off by closing the switch 18 and thus short-circuiting the terminals of the laser diode LD (step 108). In this situation, the laser LD in fact would otherwise be in excessive pumping conditions for the limits allowed by its field of application, due to a malfunction in the first loop 21, a failure of the photodiode PD or other reasons.

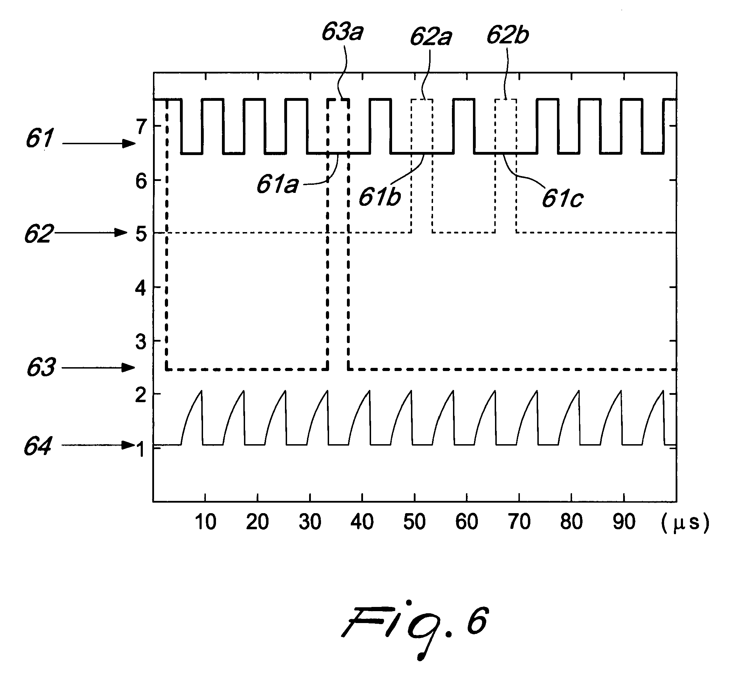

If the value of the serial word transmitted to the DAC 12 does not exceed the preset value, step 107 checks the correct operation of the other microcontroller (CPU B), as will be described in greater detail hereinafter with reference to Figure 6, resuming the cycle if CPU B also is operating correctly (step 109) or switching off the laser otherwise (step 108).

In the particular embodiment shown, the cycle of the first microcontroller CPU A is composed of 10 pulses and lasts 80 microseconds. At the first pulse, CPU A checks the analog input ADC1 in order to check for the feedback signal, while during the other pulses the CPU A performs various operations, such as checking the integrity of the loops,. This means that the power is controlled and adjusted every 80 microseconds plus the time required for control.

As regards the operation of the third loop 23, the second microcontroller CPU B, once synchronization with the first microcontroller CPU A has ended, acquires the current value of the photodiode during laser action (step 203) and compares it with the value stored in its flash memory during the trimming step. In particular, the value is compared with a value interval which is centered on the stored value and with a range of preferably 20% (step 205).

If the acquired value is outside the interval, the laser LD is switched off by closing the switch 19 (step 208). Otherwise, the microcontroller CPU B checks the correct operation of the other microcontroller CPU A as will be described hereinafter with reference to Figure 6.

The cycle is restarted from step 203 if CPU A operates correctly, otherwise CPU B is locked (entering an endless cycle) and the laser LD is switched off at step 208.

It should be noted that when one microcontroller enters an endless cycle, the other microcontroller loses synchronization and reacts immediately by closing its switch 18 or 19. One therefore has a dual safety which takes into account any defects in the closure of a switch.

Optionally, the microcontroller CPU B can measure the period and duration of the current pulse generated by the photodiode and compare it with corresponding reference values stored in its flash memory during trimming, so as to enter an endless cycle and switch off the laser in case of differences, for example of more than 20%.

As mentioned earlier, the third loop 23 is a control channel which is independent of the first channel, constituted by the first loop 21, in order to check the capability of the microcontroller CPU A to keep the emitted laser power constant. If there is damage in the first channel, the third channel can act as soon as the measured power leaves the allowed 20% window, short-circuiting the terminals of the laser diode LD.

During the trimming step, the microcontroller CPU B also acquires the value of the current I_{LED} in the photodiode PD when the laser is driven below threshold and stores said value in its flash memory.

Therefore, during normal operation, CPU B also measures at preset instants the current generated by the photodiode PD when the below-threshold current is injected (step 204) into the laser diode LD via the second loop 22 (step 204). CPU B closes the switch 19 if said value is outside the limits, for example ±20%, beyond the stored current value I_{LED} (steps 206 and 208) or restarts the cycle after checking the correct operation of the CPU A (step 207).

As regards solely steps 107 and 207, in which the two microcontrollers mutually check operation, the following can be observed with reference to Figure 6.

As mentioned earlier, the first microcontroller CPU A generates pulses preferably at 125 kHz with a duty cycle of 50% to drive the laser. These pulses are designated by the reference numeral 61 in Figure 6 and in the particular case shown they are nonperiodic in the points 61a, 61b and 61 c, in which the laser would emit a pulse which lasts longer than the other instants.

The first microcontroller synchronizes with the second one, indicating the points 61 a, 61b and 61c. This synchronization allows to separate the "long" pulses generated at the points 61 a, 61b and 61 c into two pulses of the same frequency and duration as the others. In particular, the first microcontroller CPU A indicates to the second microcontroller CPU B to separate the long pulses and accordingly the microcontroller CPU B activates the switch 19 to switch off the laser LD at the first nonperiodic point 61a, as shown by the curve 63 and by the peak 63a related to the closure signal of the switch 19.

Likewise, the microcontroller CPU A controls the switch 18 so as to close it at the points 61b and 61c, as shown by the curve 62 and by the peaks 62a and 62b related to the closure signal of the switch 18.

If the switches and the microcontrollers operate correctly, the result is a periodic curve and therefore a periodic generation of pulses, as shown schematically by the overlap of the curve 61 with the peaks 63a, 62a and 62b in Figure 6. Accordingly, the current 64 generated by the photodiode PD has a periodic behavior.

If one or both of the switches or one of the microcontrollers does not operate correctly, the response of the photodiode PD is nonzero in at least one of the points 61 a, 61b or 61 c. Therefore, if the second microcontroller CPU B detects a photodiode current which is nonzero in the point 61 a, it closes the switch 19 to switch off the laser LD, and likewise if the first microcontroller CPU A detects a nonzero photodiode current in the point 61b or 61c it closes the switch 18.

Further, if one or both of the microcontrollers change speed, i.e., if the frequency of the loop changes and the microcontrollers are not yet synchronized, both microcontrollers are programmed to react immediately and close the switches 18 and 19 in accordance with the 80-microsecond period plus the time required for verification.

In practice it has been found that the method and the circuit according to the invention fully achieve the intended aim and objects, since in the second control channel it is capable of preventing dangerous situations caused by malfunctions of the photodiode without having to resort to a second photodiode which is external to the laser module.

Although the method and the circuit according to the invention have been conceived in particular for solid-state lasers, they can be used in any case more generally with lasers of any kind which have an emission condition which is substantially insensitive to variations in temperature or other environmental parameters which can be monitored by means of a second control channel. The insensitivity can be quantified as variations on the order of 5-10% or less.

The method and the circuit thus conceived are susceptible of numerous modifications and variations, all of which are within the scope of the appended claims. All the details may further be replaced with other technically equivalent elements.

Where technical features mentioned in any claim are followed by reference signs, those reference signs have been included for the sole purpose of increasing the intelligibility of the claims and accordingly, such reference signs do not have any limiting effect on the interpretation of each element identified by way of example by such reference signs.

## Claims

1. A method for safely controlling the emission power of a laser (LD) coupled to a photodetector (PD), in which the power emitted by said laser is substantially insensitive to variations in temperature or other environmental variables for at least one value of the pumping intensity, **characterized in that** it comprises the steps of: pumping said laser (LD), at preset instants, according to said at least one value of the pumping intensity, and measuring a corresponding response of said photodetector (PD) to the light emitted by the laser during said instants, in order to check the correct operating condition of said photodetector (PD).

2. The method according to claim 1, wherein said laser (LD) is of the solid-state type and is normally pumped over threshold so that it emits laser light, said at least one value of the intensity being a value of current below the amplified stimulated emission threshold of said laser.

3. The method according to claim 1 or 2, further comprising the step of comparing said response with an expected value or with an interval of expected values and, if said response is different from said value or lies outside said interval of values, switching off said laser (LD).

4. The method according to claim 2 or 3, further comprising the step of, when the laser (LD) is pumped above threshold, comparing the emitted peak laser power, measured by means of said photodetector (PD), and a preset peak power, and adjusting the over-threshold pumping of said laser according to the outcome of said comparison, so that the peak laser power is independent of the temperature of said laser (LD).

5. The method according to one or more of the preceding claims, further comprising the step of switching off said laser (LD) if, by means of said photodetector (PD), no power emitted by said laser when the laser is pumped over threshold is detected.

6. The method according to one or more of the preceding claims, wherein said photodetector (PD) is a photodiode and said response of the photodetector is the current generated in the photodiode in response to the light emitted by said laser (LD).

## Patentansprüche

1. Ein Verfahren zur sicheren Steuerung der Emissionsleistung eines Lasers (LD), der mit einem Photodetektor (PD) gekoppelt ist, wobei die von dem Laser emittierte Leistung im Wesentlichen unempfindlich ist gegenüber Schwankungen der Temperatur oder anderer Umweltvariablen für mindestens einen Wert der Pumpintensität, **dadurch gekennzeichnet, dass** es folgende Schritte umfasst: Pumpen des Lasers (LD), zu voreingestellten Zeitpunkten, entsprechend dem mindestens einen Wert der Pumpintensität und Messen einer entsprechenden Reaktion des Photodetektors (PD) auf das Licht, das vom Laser während der Zeitpunkte emittiert wird, um den korrekten Betriebszustand des Photodetektors (PD) zu testen.

2. Das Verfahren gemäß Anspruch 1, worin der Laser (LD) vom Festkörpertyp ist und normalerweise über den Schwellenwert gepumpt wird, so dass er Laserlicht abgibt, wobei der mindestens eine Wert der Intensität ein Wert des Stroms unterhalb des verstärkten stimulierten Emissions-Schwellenwerts des Lasers ist.

3. Das Verfahren gemäß Anspruch 1 oder 2, das weiter folgenden Schritt umfasst: Vergleichen der Reaktion mit einem Erwartungswert oder mit einem Intervall von Erwartungswerten und, falls die Reaktion sich von dem Wert unterscheidet oder außerhalb des Intervalls von Werten liegt, Ausschalten des Lasers (LD).

4. Das Verfahren gemäß Anspruch 2 oder 3, das weiter folgenden Schritt umfasst: wenn der Laser (LD) über den Schwellenwert gepumpt wird, Vergleichen der emittierten Spitzen-Laserleistung, gemessen mit Hilfe des Photodetektors (PD), und einer voreingestellten Spitzenleistung, und Anpassung des Über-den-Schwellenwert-Pumpens des Lasers entsprechend dem Ergebnis des Vergleichs, so dass die Spitzen-Laserleistung unabhängig von der Temperatur des Lasers (LD) ist.

5. Das Verfahren gemäß einem oder mehreren der obigen Ansprüche, das weiter folgenden Schritt umfasst: Ausschalten des Lasers (LD), wenn mit Hilfe des Photodetektors (PD) keine von dem Laser emittierte Leistung, wenn der Laser über den Schwellenwert gepumpt wird, erfasst wird.

6. Das Verfahren gemäß einem oder mehreren der obigen Ansprüche, worin der Photodetektor (PD) eine Photodiode ist und die Reaktion des Photodetektors der Strom ist, der in der Photodiode als Reaktion auf das von dem Laser (LD) emittierte Licht erzeugt wird.

## Revendications

1. Procédé pour commander de façon sûre la puissance d'émission d'un laser (LD) couplé à un photodétecteur (PD), dans lequel la puissance émise par ledit laser est sensiblement insensible à des variations de température ou d'autres variables environnementales pour au moins une valeur de l'intensité de pompage, **caractérisé en ce qu'**il comprend les étapes consistant à : pomper ledit laser (LD), à des instants pré-établis, en fonction de ladite au moins une valeur de l'intensité de pompage, et mesurer une réponse correspondante dudit photodétecteur (PD) à la lumière émise par le laser durant lesdits instants, afin de vérifier la condition de fonctionnement correcte dudit photodétecteur (PD).

2. Procédé selon la revendication 1, dans lequel ledit laser (LD) est du type à semiconducteurs et est normalement pompé au-dessus d'un seuil de telle sorte qu'il émette une lumière de laser, ladite au moins une valeur de l'intensité étant une valeur de courant inférieure au seuil d'émission stimulé amplifié dudit laser.

3. Procédé selon la revendication 1 ou 2, comprenant de plus l'étape de comparaison de ladite réponse à une valeur prévue ou à un intervalle de valeurs prévues, et, si ladite réponse est différente de ladite valeur ou se trouve à l'extérieur dudit intervalle de valeurs, de commutation d'interruption dudit laser (LD).

4. Procédé selon la revendication 2 ou 3, comprenant de plus l'étape, lorsque le laser (LD) est pompé au-dessus du seuil, de comparaison du pic de puissance de laser émis, mesuré à l'aide dudit photodétecteur (PD), et d'un pic de puissance pré-établi, et de réglage du pompage au-dessus du seuil dudit laser en fonction du résultat de ladite comparaison, de telle sorte que le pic de puissance de laser soit indépendant de la température dudit laser (LD).

5. Procédé selon l'une ou plusieurs des revendications précédentes, comprenant de plus l'étape de commutation d'interruption dudit laser (LD), si, à l'aide dudit photodétecteur (PD), aucune puissance émise par ledit laser lorsque ledit laser est pompé au-dessus du seuil n'est détectée.

6. Procédé selon l'une ou plusieurs des revendications précédentes, dans lequel ledit photodétecteur (PD) est une photodiode et ladite réponse du photodétecteur est le courant généré dans la photodiode en réponse à la lumière émise par ledit laser (LD).
